# EUROPEAN PATENT APPLICATION

(11) **EP 3 051 296 A1**
(43) Date of publication of application: **03.08.2016**
(21) Application number: 15200235.8
(22) Date of filing: 15.12.2015
(51) Int. Cl.: G01R 1/04, G01R 1/16, H01R 13/62, G01R 1/073

(54) **MAGNETIC ANCHOR FOR TEST PROBES WITH METAL BANDS**

(30) Priority: 16.12.2014 US 201414571569
(71) Applicant: Tektronix, Inc., Beaverton, Oregon 97077-0001 (US)
(72) Inventor: McGrath, James, Aloha, PA Pennsylvania 97007 (US)
(74) Representative: Clarke, Jeffrey David

(57) **Abstract**

A magnetic anchor base assembly (150) can include a magnetic coupling component (155) and magnetic sub-components (215-235) integrated therewith. Each magnetic sub-component can be configured to magnetically couple with a metal band (118-148) that is configured to couple with a test probe (110-140).

## Description

### Technical Field

This disclosure relates generally to test probes and other devices used for testing circuit boards and devices thereon.

### Background

Today's probing applications require connecting test probes to very small devices on circuit boards for testing. These connections from a probe to a device under test (DUT) are usually established by way of very fine wire (e.g. 0.1016 to 0.2032 millimeter, or 0.004-0.008" inch). A typical probe assembly typically includes a compensation box mounted to an oscilloscope, a coaxial cable of some length (e.g., 36-47"), and a test probe having a probe tip.

When the probe tip is connected to the DUT, any movement or force from either the circuit board assembly or the probe assembly (including the cable) will transfer to the fine wire connection between the DUT and the probe tip, undesirably and disadvantageously causing a break in the electrical path. Prior attempted solutions include taping or gluing probe tips to the circuit board assembly nearest to the DUT, thus eliminating any cable pull on the wires. However, this has been a significant concern to users, who would prefer to have some sort of solution for mechanical strain relief near the probe tip.

Accordingly, a need remains for improved test probe assemblies.

### Summary

Embodiments of the disclosed technology generally pertain to magnetic anchor base assemblies configured to couple with one or more test probes to provide protection thereto from unintentional bumps or other movements that could otherwise cause a disruption or break to the electrical connection that has been established between the test probe(s) and a device under test (DUT).

### Brief Description of the Drawings

FIGURE 1 illustrates an example of test probes securably coupled with a magnetic anchor base assembly in accordance with certain embodiments of the disclosed technology.
FIGURE 2 illustrates a first example of test probes securably coupled with a magnetic coupling component in accordance with certain embodiments of the disclosed technology.
FIGURE 3 illustrates a second example of test probes securably coupled with a magnetic coupling component in accordance with certain embodiments of the disclosed technology.

### Detailed Description

Embodiments of the disclosed technology generally pertain to various systems and methods for providing protection, for example mechanical protection, e.g., from bumps or other inadvertent movements that could cause a disruption or even full break to an electrical connection, to a test probe (including the test probe tip) positioned at or near one or more connection points to a device under test (DUT).

Certain embodiments of the disclosed technology may include a flex circuit and flex connector that are small, lightweight, flexible, and provide a flat surface for easy attachment (e.g., VHB tape or glue) to a printed circuit board (PCB).

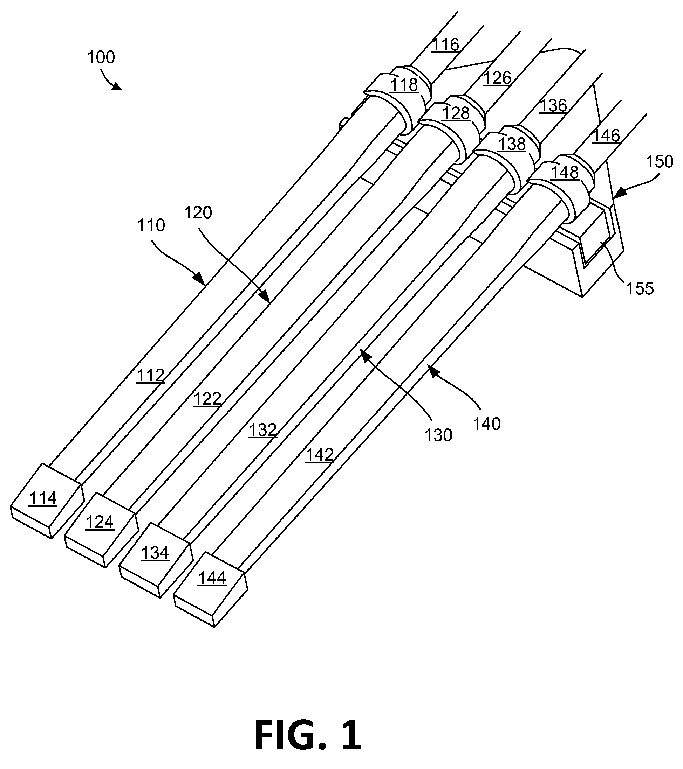

FIGURE 1 illustrates a first example 100 of test probes 110, 120, 130, and 140 that are securably coupled with a magnetic anchor base assembly 150 in accordance with certain embodiments of the disclosed technology. Each test probe 110, 120, 130, and 140 includes a flex body 112, 122, 132, and 142, respectively, and a cable 116, 126, 136, and 146, respectively, connect to a testing device (also known as a test instrument), e.g., an oscilloscope.

Each test probe 110, 120, 130, and 140 also includes a flex connector 114, 124, 134, and 144, respectively, that is configured to physically couple with and electrically connect to a flex circuit (not shown) that is configured to be integrated with or otherwise be electrically coupled with a DUT (not shown), thus providing the electrical coupling between the DUT and the testing device.

In the example 100, a magnetic anchor base assembly 150 includes a magnetic coupling component 155 that is configured to securably couple each of the test probes 110, 120, 130, and 140 therewith by way of metal bands 118, 128, 138, and 148, respectively. Each of the metal bands 118, 128, 138, and 148 may be permanently or temporarily integrated with, attached to, or otherwise coupled with the test probes 110, 120, 130, and 140, respectively. Providing such an anchor point at this transition may advantageously eliminate any potential pull issue with regard to either the flex circuits or cables 116, 126, 136, and 146.

In certain embodiments, the magnetic anchor base assembly 150 is a heavy metal base that may incorporate several strong Neodymium magnets. The bottom of the anchor base assembly 150 may include a non-conductive, high friction (e.g., sticky) sheet that provides additional shear resistance for mounting the anchor base assembly 150 near the DUT.

The magnetic coupling component 155 of the magnetic anchor base assembly 150 may be separated for additional attachment options using the magnetics. For example, the magnetic coupling component 155 may be placed on virtually any ferrous metal surface (e.g., tables or fixtures) thus providing a user with the ability to position any or all of the test probes 110, 120, 130, and 140 in multiple distinct orientations.

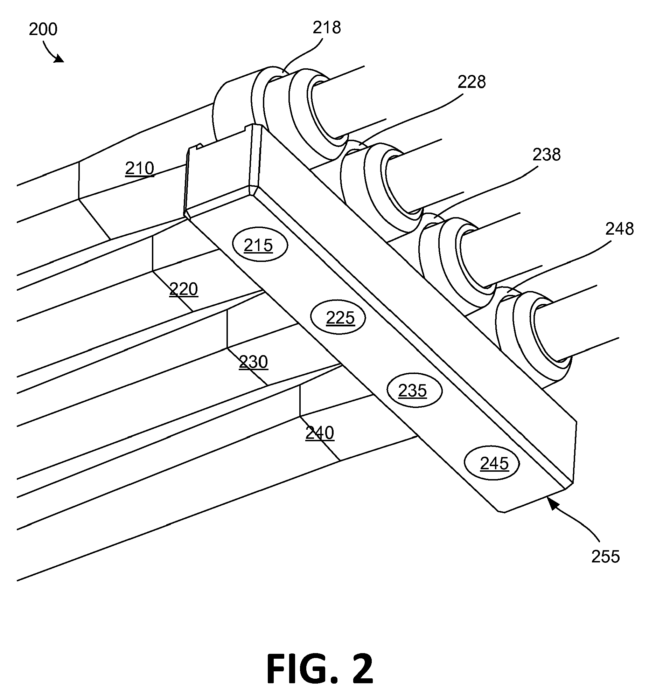

FIGURE 2 illustrates a first example 200 of test probes 210, 220, 230, and 240 that are securably coupled with a magnetic coupling component 255, such as the magnetic coupling component 155 illustrated by FIGURE 1, in accordance with certain embodiments of the disclosed technology. In the example, magnetic sub-components 215, 225, 235, and 245, e.g., Neodymium magnets, are integrated with the magnetic coupling component 255 to facilitate or otherwise perform the magnetic coupling between the magnetic coupling component 255 and the test probes 210, 220, 230, and 240, respectively, by way of metal bands 218, 228, 238, and 248 that are integrated with, attached to, or otherwise coupled with the test probes 210, 220, 230, and 240, respectively.

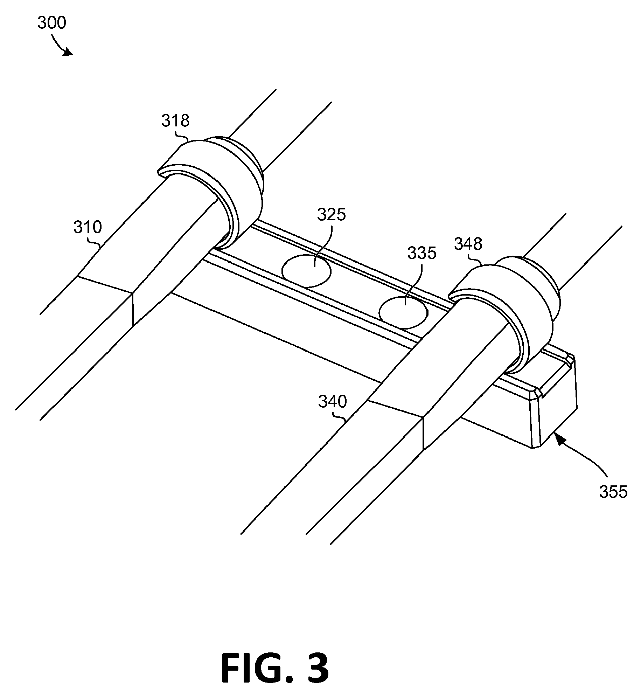

FIGURE 3 illustrates a second example 300 of test probes 310 and 340 that are securably coupled with a magnetic coupling component 355, such as the magnetic coupling component 155 illustrated by FIGURE 1, in accordance with certain embodiments of the disclosed technology. In the example, magnetic sub-components, e.g., Neodymium magnets, are integrated with the magnetic coupling component 355 to facilitate or otherwise perform the magnetic coupling between the magnetic coupling component 355 and the test probes 310 and 340 by way of metal bands 318 and 348, respectively, that are integrated with, attached to, or otherwise coupled with the test probes 310 and 340, respectively. In the example, two magnetic sub-components 325 and 335 are not currently coupled with a test probe.

In certain embodiments, one or more metal bands (e.g., the metal bands 118, 128, 138, and 148 of FIGURE 1) that are attached to test probes (e.g., the test probes 110, 120, 130, and 140 of FIGURE 1) may be colored, e.g., for scope channel identification. For example, each of the metal bands may have a specific color for visually enabling a user to identify which channel corresponds to the test probe with which that metal band is coupled. Designing colored marker bands in a ferrous metal may advantageously allow a user to attach the cable end of a probe assembly to a magnetic anchor base assembly configured to provide strong cable strain relief.

Examples provide a magnetic anchor base assembly, comprising a magnetic coupling component, and at least one magnetic sub-component integrated with the magnetic coupling component, wherein each of the at least one magnetic sub-component is configured to magnetically couple with a metal band, and wherein the metal band is configured to couple with a test probe.

Some examples further comprise a magnetic anchor base body, wherein the magnetic coupling component is configured to securably couple with the magnetic anchor base body.

In some examples, the magnetic anchor base body includes a non-conductive, high friction sheet configured to facilitate physical coupling of the magnetic anchor base assembly with a surface.

In some examples, the magnetic coupling component is configured to magnetically couple with a surface.

In some examples, the at least one magnetic sub-component is a Neodymium magnet.

In some examples, the metal band is a certain color that corresponds to a particular channel on a test instrument.

Examples provide a system, comprising a plurality of test probes, a plurality of metal bands, each of which is configured to physically couple with one of the plurality of test probes, and a magnetic anchor base assembly that includes a magnetic anchor base body, a magnetic coupling component, wherein the magnetic coupling component is configured to securably couple with the magnetic anchor base body, and at least one magnetic sub-component integrated with the magnetic coupling component, wherein each of the at least one magnetic sub-component is configured to magnetically couple with one of the plurality of metal bands.

In some examples, each of the plurality of metal bands is a certain color that corresponds to a particular channel on a test instrument.

In some examples, the system is a test instrument, for exmaple an oscilloscope.

Some examples further comprise at least one flex circuit configured to electrically couple with a device under test (DUT), wherein each of the plurality of test probes includes a flex body, and a flex connector configured to electrically couple with one of the at least one flex circuit.

Having described and illustrated the principles of the invention with reference to illustrated embodiments, it will be recognized that the illustrated embodiments may be modified in arrangement and detail without departing from such principles, and may be combined in any desired manner. And although the foregoing discussion has focused on particular embodiments, other configurations are contemplated. For example, embodiments of the present disclosure are not limited to any particular number of test probes.

In particular, even though expressions such as "according to an embodiment of the invention" or the like are used herein, these phrases are meant to generally reference embodiment possibilities, and are not intended to limit the invention to particular embodiment configurations. As used herein, these terms may reference the same or different embodiments that are combinable into other embodiments.

Consequently, in view of the wide variety of permutations to the embodiments that are described herein, this detailed description and accompanying material is intended to be illustrative only, and should not be taken as limiting the scope of the invention. What is claimed as the invention, therefore, is all such modifications as may come within the scope of the following claims and equivalents thereto.

## Claims

1. A magnetic anchor base assembly, comprising:
a magnetic coupling component; and
at least one magnetic sub-component integrated with the magnetic coupling component;
wherein each of the at least one magnetic sub-component is configured to magnetically couple with a metal band; and
wherein the metal band is configured to couple with a test probe.

2. The magnetic anchor base assembly of claim 1, further comprising a magnetic anchor base body, wherein the magnetic coupling component is configured to securably couple with the magnetic anchor base body.

3. The magnetic anchor base assembly of claim 2, wherein the magnetic anchor base body includes a non-conductive, high friction sheet configured to facilitate physical coupling of the magnetic anchor base assembly with a surface.

4. The magnetic anchor base assembly of any previous claim, wherein the magnetic coupling component is configured to magnetically couple with a surface.

5. The magnetic anchor base assembly of any previous claim, wherein the at least one magnetic sub-component is a Neodymium magnet.

6. The magnetic anchor base assembly of any previous claim, wherein the metal band is a certain color that corresponds to a particular channel on a test instrument.

7. A system, comprising:
a plurality of test probes;
a plurality of metal bands, each of which is configured to physically couple with one of the plurality of test probes; and
a magnetic anchor base assembly according to any of claims 1 to 6, that further includes:
at least one magnetic sub-component integrated with the magnetic coupling component, wherein each of the at least one magnetic sub-component is configured to magnetically couple with one of the plurality of metal bands.

8. The system of claim 7, wherein each of the plurality of metal bands is a certain color that corresponds to a particular channel on a test instrument.

9. The system of claim 8, wherein the system is a test instrument.

10. The system of claim 9, wherein the test instrument is an oscilloscope.

11. The system of any of claims 7 to 10, further comprising at least one flex circuit configured to electrically couple with a device under test DUT, wherein each of the plurality of test probes includes:
a flex body; and
a flex connector configured to electrically couple with one of the at least one flex circuit.
